# EUROPEAN PATENT APPLICATION

(11) **EP 4 404 260 A1**
(43) Date of publication of application: **24.07.2024**
(21) Application number: 23386003.0
(22) Date of filing: 20.01.2023
(51) Int. Cl.: H01L 25/16, H01L 21/60, G06N 10/40

(54) **FLIP CHIP ASSEMBLY**

(71) Applicant: Quantum Brilliance GmbH, 70565 Stuttgart (DE)
(72) Inventor: BOUGAS, Lykourgos, 70565 Stuttgart (DE); RAVEN, Carsten, 70565 Stuttgart (DE)
(74) Representative: Sonnenberg Harrison Partnerschaft mbB

(57) **Abstract**

A flip-chip assembly (1) of an integrated solid-state quantum circuit is disclosed. The assembly comprises a first chip (10) hosting a plurality of qubits in a first semiconductor substrate (12) and a second chip (20) comprising a second semiconductor substrate (22) bonded to the first chip (10). The second chip (20) comprises a plurality of control structures (24) and read-out structures (26) and the first semiconductor substrate (12) is a diamond substrate. The document also teaches fabrication of the flip-chip assembly.

## Description

### Cross-Reference to Related Applications

None

### Field of the Invention

The present document describes a method and an assembly of integrated solid-state quantum circuits (ISSQC) with an interconnection of a semiconductor substrate and read-out structures, control structures and semiconductor devices using flip-chip technology.

### Background of the Invention

An integrated solid-state quantum circuit (ISSQC) is an integrated circuit able to address, control, and detect quantum state(s) of solid-state qubits for applications in quantum technologies and quantum computing. The integrated solid-state quantum circuit comprises a semiconductor substrate (or a semiconductor device hosting a plurality of qubits), control structures able to manipulate the qubits, as well as read-out structures used for controlling the control structures. The read-out structures are also used for collecting optical signal, electrical signals, or magnetic signals from the qubits and spin defects present in the semiconductor substrate.

The qubits are addressed and manipulated using at least one of the optical fields, electric fields, and magnetic fields.

The control structures are used for delivering the optical fields, electric fields and/or magnetic fields as well as for control, initialization, manipulation, and read-out of a spin state of a given qubit in the semiconductor substrate.

The read-out structures are, for example, analog circuits, digital circuits, transistors, logic devices, sensor devices, light emitting devices and light collecting devices.

Central components of the ISSQC, such as the semiconductor substrate, the control structures, and the read-out structures, can be fabricated by two approaches. In a first approach the central components of the ISSQC are integrated directly in one device (a monolithic fabrication process) using, for example, a bottom-up fabrication process. In a second approach, the central components of the ISSQC are fabricated separately into distinct devices and integrated to the ISSQC at a later stage (e.g., a flip-chip assembly).

### Prior Art

The monolithic fabrication process is a known approach for on-chip integration of semiconductor waveguides, transistors, semiconductor quantum processors, photon sources and is described in a number of publications.

For example, US Patent No US 11,171,225 B2 (University of Toronto) describes monolithically integrated semiconductor quantum processors.

K. D. Jöns et al," Monolithic on-chip integration of semiconductor waveguides, beam splitters and single-photon sources" J. Phys. D: Appl. Phys. 48 085101 (2015) describes a monolithic on-chip integration of semiconductor waveguides, beam splitters and single-photon sources.

According to the prior art, the monolithic fabrication processes suffer from lack of flexibility in circuit design and may result into poorer isolation between fabricated components. Additionally, quality control tests on the fabricated components in the ISSQC can be performed only when the entire ISSQC is assembled. These quality control tests may indicate, for example, an absence of a signal from the plurality of qubits that are read-out from control structures in the device. A drawback of the monolithic fabrication process is a difficulty in determining a reason for the absence of the signal from the qubits. This absence of the signal may be related to problems during fabrication of the qubits or to problems during fabrication of the semiconductor devices (e.g., misalignment of the semiconductor devices).

However, none of the known prior art documents discloses the monolithic fabrication process of the central components of the ISSQC, such as the semiconductor substrate (e.g., a diamond substrate), the control structures and the read-out structures.

Another approach for fabrication of the central components of the ISSQC is the separate fabrication of distinct devices for the individual central components. The separate fabrication process allows a separate optimization of the fabrication of the semiconductor substrate (with the qubits) and of the semiconductor device hosting the control structures and associated circuits. This separate fabrication enables optimization of the semiconductor substrate for increased efficiency of the semiconductor devices, for example, by selection of the material properties, atomic scale fabrication of qubits, optimization of dopants, or even different materials.

The separate fabrication of the central components of the ISSQC enables the use of established technologies and established materials for development of the semiconductor devices comprising the control structures and integrated circuits (ICs). The separate fabrication can exploit, for example, the capabilities of established CMOS technologies. The separate fabrication also enables the ability to parallelize the fabrication processes into different steps.

The separate fabrication of the central components of the ISSQC also enables the testing of the semiconductor substrates separately before the integration of the entire ISSQC. Electromagnetic compatibility (EMC) testing, fabrication testing and signal transduction testing can be applied to the control structures and read-out structures separately. Therefore, the separate fabrication allows to determine a potential problem with coupling to the qubits or the absence of the signals from the qubits. The presence of the qubits within a first semiconductor substrate with expected coherence properties and satisfying couplings can also be determined.

A drawback of the separate fabrication approach is the demands on an interconnection technology, particularly if a plurality of the spin defects is present. The spin defects (e.g., the qubits) must be addressed within one-dimensional, two-dimensional, or three-dimensional arrangements.

The prior art teaches a fabrication of diamond-based devices hosting NV-centers for quantum technologies and quantum computing applications. The production of diamond-based devices uses the fabrication of the control structures (e.g., coils, transmission lines) either directly onto the diamond substrate or onto separate materials/devices.

For example, Tim Schröderet al. "Quantum nanophotonics in diamond" Journal of the Optical Society of America B 33, B65 (2016) reviews recent advances in diamond nano-and microphotonic structures for efficient light collection, color center to nanocavity coupling, hybrid integration of diamond devices with other material systems, and the wide range of fabrication methods that have enabled complex photonic diamond systems.

John F. Barry et al. "Sensitivity optimization for NV-diamond magnetometry" Rev. Mod. Phys. 92, 015004 (2020) discloses approaches to enhance the sensitivity of broadband ensemble-NV-diamond magnetometers, improvements to the spin dephasing time, the readout fidelity, and the host diamond material properties.

Emilie Bourgeois et al. "Photoelectric Detection and Quantum Readout of Nitrogen-Vacancy Center Spin States in Diamond", Adv. Optical Mater. 8, 1902132 (2020) discloses a method for reading out the electron spin state of the negatively charged nitrogen-vacancy (NV) point defect in diamond, based on photoelectric detection of NV magnetic resonances.

H. Zhang et al. "Selective addressing of solid-state spins at the nanoscale via magnetic resonance frequency encoding" npj Quantum Information 3,31 (2017) describes a nanoscale magnetic resonance frequency encoding to realize site-selective addressing and coherent control of a four-site array of NV spins.

Christopher Foy et al. "A CMOS-integrated quantum sensor based on nitrogen-vacancy centres" Nature Electronics 2, 284 (2019) discloses a NV-based quantum sensing integrated with complementary metal-oxide-semiconductor (CMOS) technology to create a compact and scalable platform.

Mikhail Y. Shalaginov et al. "On-Chip Single-Layer Integration of Diamond Spins with Microwave and Plasmonic Channels", ACS Photonics 7, 2018 (2020) discloses an on-chip integrated structure for nitrogen vacancy (NV) spin-based applications, implemented in a single material layer with one patterning step.

M. I. Ibrahim et al. "A Scalable Quantum Magnetometer in 65nm CMOS with Vector-Field Detection Capability," 2019 IEEE International Solid- State Circuits Conference - (ISSCC), 2019, pp. 458-461, doi: 10.1109/ISSCC.2019.8662434 discloses a CMOS-NV quantum sensor with a highly scalable microwave-delivering structure and a Talbot-effect-based photonic filter with enhanced green-to-red suppression ratio.

However, both the direct fabrication and the separate fabrication currently use wire bonding or direct device contacting to achieve an interconnection between the semiconductor substrate and the control structures. Therefore, it is advantageous to develop architectures that allow for the direct interconnection between the semiconductor substrate and the control structures and read-out structures.

Quantum devices and technologies, based on solid-state qubits, require optical fields and/or magnetic fields and electric fields for initialization, manipulation, and/or read-out of the spin state of the qubit(s).

One known solution to enable the connection of two different semiconductor substrates is flip-chip technology. The flip-chip technologies offer a solution to separate fabrication challenges for the assembly process by using, for example, flip-chip solder bumping, compression, fusion, or thermal bonding. The flip-chip technologies allow the vertical integration of different ones of the semiconductor substrates and the control structures into a hybrid integrated circuit and enable scalable fabrication approaches.

Several prior art documents are known that describe use of flip-chip technology for ISSQC. For example, international patent application No. WO2022008792A1 (IQM Technology) discloses a quantum computing circuit comprising two chips that are stacked together in a flip-chip configuration and attached to each other with bump bonding that comprises bonding bumps. A first chip is made of aluminum oxide, copper, palladium and a second chip is made from the materials different from the first chip to avoid undesired interacting between the qubits and other circuit elements of a quantum processor.

US Patent No. US10355193B2 (IBM) describes a quantum bit (qubit) flip-chip assembly which comprises a qubit formed on a first chip and an optically transmissive path formed on a second chip. The two chips are bonded using solder bumps. The optically transmissive path may provide optical access to the qubit on the first chip. The first chip has a semiconductor substrate made of high-resistivity silicon wafer.

US Patent Application No. US20040182914A1 (Emcore) discloses a p-type contact for flip-chip bonding and electrically contacting a p-type group III-nitride layer of a group III-nitride flip-chip light-emitting diode die with a bonding pad.

US Patent Application No. US6262489B1 (Delphi) discloses a method and assembly for mounting an IC semiconductor device to a substrate using flip-chip technology.

US Patent Application No. US7049704B2 (Intel), disclosed a package allowing both electrical and optical coupling between one or more integrated circuits and a printed circuit board having an optical waveguide structure in addition to electrical connections.

US Patent Application No. US6265775B1 (Micron) discloses a flip-chip semiconductor die connected to an opposing substrate, such as a silicon wafer.

Matsumae T et al. "Low-temperature direct bonding of InP and diamond substrates under atmospheric conditions". Sci Rep. 2021 May 27;11(1):11109. doi: 10.1038/s41598-021-90634-4. PMID: 34045611; PMCID: PMC8159945 discloses an InP substrate that is directly bonded on a diamond heat spreader for efficient heat dissipation.

The use of a diamond substrate for quantum chips is known, for example, from German Patent Application No. DE102020125183A1 (Quantum Tech GmbH) which discloses a scalable quantum computer based on a diamond substrate with impurity centers with a CMOS circuit.

International patent application No. WO2021051163A1 (ANU) discloses a quantum information processing device with a diamond substrate, assembly, arrangement, system, and sensor.

One of the challenges in using flip chip technology for ISSQC fabrication is to connect a diamond substrate to the semiconductor devices without wire bonding. A further challenge for the flip chip technology for ISSQC is controlling physical properties of the connection between the quantum substrate and semiconductor devices.

### Brief summary of the Invention.

This document teaches a flip-chip assembly for an integrated solid-state quantum circuit. The flip-chip assembly comprises a first chip hosting a plurality of qubits in a first semiconductor substrate and a second chip comprising a second semiconductor substrate bonded to the first chip. The second chip comprises a plurality of control structures and read-out structures. The first semiconductor substrate is a diamond substrate.

The use of the second chip structures enables the control structures and the read-out structures to be easily manufactured on the second chip and then connected to the qubits in the first chip by flip-chip bonding. The assembly and method described in this document can therefore avoid wire bonding and enable small form-factors and vertical integration. The vertical integration enables connection of the qubits in the diamond substrate to the control structures and the read-out structures.

The qubits in the first semiconductor substrate comprise at least one spin defect. The first semiconductor substrate may further comprise impurities selected from at least one of boron, aluminum, gallium, indium, thallium, nihonium, nitrogen, phosphorus, arsenic, antimony, bismuth, beryllium, lithium. These impurities help in charge stabilization of the qubits and can also impact the coherence properties of the qubits.

In a further aspect, the read-out structures are integrated into a third chip.

The second semiconductor substrate comprises, for example, a transparent material which enables the manufacture of optical waveguides in the second semiconductor substrate.

This document also describes a method of assembling of an integrated solid-state quantum circuit. The method comprises providing a first chip hosting a plurality of qubits in a first semiconductor substrate, wherein the first semiconductor substrate is a diamond substrate. The method also comprises fabricating a plurality of control structures and read-out structures onto a second semiconductor substrate and subsequently aligning the first chip to the second chip. Finally, the first chip is bonded to the second chip, thereby forming a flip-chip assembly.

The spin defects are fabricated, for example, by atomic-scale fabrication in the first semiconductor substrate and the spin defects are controlled via chemical, electrical, thermal, optical procedures, or ion irradiation.

The bonding of the first chip to the second chip is carried out by at least one of metal-to-semiconductor bonding, metal-to-metal bonding, solder bump bonding, adhesive bonding, thermal-compression bonding, vacuum bonding, eutectic-fusion bonding, or anodic bonding.

In a further aspect, the plurality of control structures and read-out structures are developed onto a third chip.

After bonding, the method comprises testing of the flip-chip assembly and verification of alignment and bonding of the first chip and the second chip or third chip.

Finally, the method comprises packaging of the flip-chip assembly. The packaging is for at least one of thermal management or electric shielding, magnetic shielding, and/or irradiation shielding.

The method and the flip-chip assembly of the complete ISSQC enables a decoupling of fabrication process between separate semiconductor substrates and onto separate semiconductor substrates. The method and the flip-chip assembly of the complete ISSQC enables circumventing the need for wire bonding. The method and assembly of the present document lead towards smaller scale chips. The flip-chip techniques offer the possibility of vertical integration of the semiconductor substrates and therefore the flip-chip techniques help reduce an overall area occupied by read-out structures and control structures. The reduced overall area permits improved thermal management.

The assembly and method set out in this document also enables separation of the difficulties of generating solid-state qubits in semiconductor materials (i.e., diamond) from the difficulties of generating control structures and devices comprising the control structures and the read-out structures.

### Description of the Figures.

Fig. 1 shows a flip-chip assembly of an ISSQC using flip-chip technology.
Fig. 2 shows an alternative concept for the method and assembly of an ISSQC using flip-chip technology.
Fig. 3 shows an alternative concept of a flip-chip assembly with a first transparent semiconductor substrate.
Fig. 4 shows an alternative concept of a flip-chip assembly with a second transparent semiconductor substrate.
Fig. 5 shows an alternative concept of a flip-chip assembly with a light emitting device integrated into a second transparent semiconductor substrate.
Fig. 6 shows an alternative concept of a flip-chip assembly with of a light emitting device being on one side of a first semiconductor substrate.
Fig. 7 shows an alternative concept of a flip-chip assembly with a third chip comprising a light emitting device and electrical-interface routings (e.g., an interposer) between one or multiple control structures to another or multiple others.
Fig. 8 shows an assembly process for ISSQCs.

### Detailed Description of the Invention

The invention will now be described on the basis of the drawings. It will be understood that the embodiments and aspects of the invention described herein are only examples and do not limit the protective scope of the claims in any way. The invention is defined by the claims and their equivalents. It will be understood that features of one aspect or embodiment of the invention can be combined with a feature of a different aspect or aspects and/or embodiments of the invention.

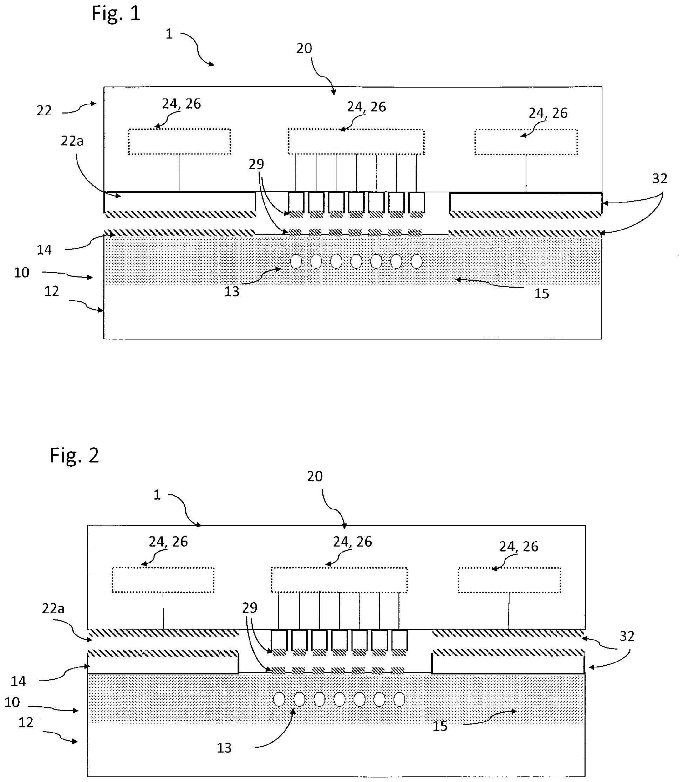

Fig. 1 describes a first aspect of the invention. Fig. 1 shows a flip-chip assembly 1 of an ISSQC using flip-chip technology. The flip-chip assembly 1 comprises a first chip 10 with a first semiconductor substrate 12, and a second chip 20 with a second semiconductor substrate 22. The flip-chip assembly 1 comprises a flip-chip bonding interconnection 32 that connects the first chip 10 with the second chip 20. The second semiconductor substrate 22 comprises control structures 24 and readout structures 26.

The first semiconductor substrate 12 is termed "front-end-of-line (FEOL)" portion of the fabrication process and the FEOL is a first portion of the flip-chip assembly 1. The first semiconductor substrate 12 has bulk spin defects 13 (as shown in Fig. 1), but this is not limiting of the invention. For example, there could be surface spin defects 13 on a top surface 14 of the first semiconductor substrate 12.

The first semiconductor substrate 12 is made from diamond. The spin defects 13 may be pre-existing in the first semiconductor substrate 12. The spin defects 13 may be grown or generated onto the top surface 14 of the first semiconductor substrate 12 or into epitaxial layers or bulk material of the first semiconductor substrate 12. The spin defects 13 may also be grown or generated within the first semiconductor substrate 12. The spin defects 13 are termed "in-grown defects" and may be fabricated through atomic-scale fabrication, incorporated during growth of the first semiconductor substrate 12, or generated via particle irradiation and/or light irradiation and/or ion implantation.

In a non-limiting example, the spin defects 13 are NV centres or carbon-13 (C-13) within the diamond. The spin defects 13 serve as the qubits, such as a nuclear spin of nitrogen of the NV center. The spin defects 13 can be initialized and addressed optically, electrically, or magnetically.

In an alternative aspect, the spin defects 13 are impurities or dopant elements 15 to the first semiconductor substrate 12 as will be explained below.

The solid-state qubits in the first semiconductor substrate 12 can be addressed and manipulated using at least one of the optical fields, electric fields, and magnetic fields. The optical field, electrical field or magnetic field is transmitted between the first semiconductor substrate 12 and the control structures 24 of the second semiconductor substrate 22 as will be explained below. In one aspect, the solid-state qubits are present in the case of the nitrogen-vacancy (NV) center in the diamond and of the isotopes of carbon that possess non-zero nuclear spin. Other elements such as Si or other group-IV elements, can generate similar spin defects 13 such as Silicon-vacancy center (SiV) in the diamond of the first semiconductor substrate 12.

Activation, generation, and conversion of the spin defects 13 can be controlled via chemical procedures, electrical procedures, optical procedures, or thermal procedures (e.g., annealing), but this is not limiting aspect of the present invention.

The nitrogen vacancies (NV) centres can be generated by introducing the nitrogen into a diamond lattice. One of non-limiting examples of vacancies generation are irradiation, such as ion irradiation, electron radiation, proton irradiation or laser light irradiation. In an alternative aspect, the nitrogen is introduced to the diamond lattice during growth of the diamond (e.g., first semiconductor substrate 12) or incorporated through implantation or diffusion from the top surface 14 of the diamond. The diffusion of the nitrogen into the diamond lattice can be activated and/or assisted chemically, electrically or by thermal and optical annealing but this is not limiting of the present invention.

The fabrication process of the first semiconductor substrate 12 may include an introduction of impurities or dopant elements 15 to the first semiconductor substrate 12. The dopant elements 15 are electron donor and acceptor impurities. Such additional elements (e.g., dopant elements 15) can modulate the electrical, optical, and structural material properties of the first semiconductor substrate 12 as well as the properties of the solid-state qubits within the first semiconductor substrate 12. The electron donor and acceptor impurities are atomic elements that possess electronic spin and/or nuclear spin. The dopant elements 15 can be controlled and manipulated with external (electric, optical, magnetic) fields. The dopant elements 15 can be activated and/or diffused into the first semiconductor substrate 12 via the thermal annealing, the optical annealing or via the ion implantation.

Non-limiting examples of the acceptor impurities are boron, aluminum, gallium, indium, thallium, nihonium. A non-limiting example of the donor impurities is nitrogen, phosphorus, arsenic, antimony, bismuth, beryllium, lithium. The dopant elements 15 allow charge stabilization of the negatively charged NV centres in the diamond. The dopant elements 15 can also impact the coherence properties of the electronic spin state of the NV centers.

Adjusting a concentration of the added dopant elements 15 in the first semiconductor substrate 12 enables to control material properties of the first semiconductor substrate 12. It is assumed that a certain number of qubits are at known positions and known depths within the first semiconductor substrate 12.

The second semiconductor substrate 22 shown in Fig. 1 is termed a "back-end-of-line" (BEOL) portion of the ISSQC fabrication. The second semiconductor substrate 22 includes a plurality of the control structures 24 and the read-out structures 26. The control structures 24 and the read-out structures 26 are developed in or onto the separate semiconductor substrate, for example onto the second semiconductor substrate 22.

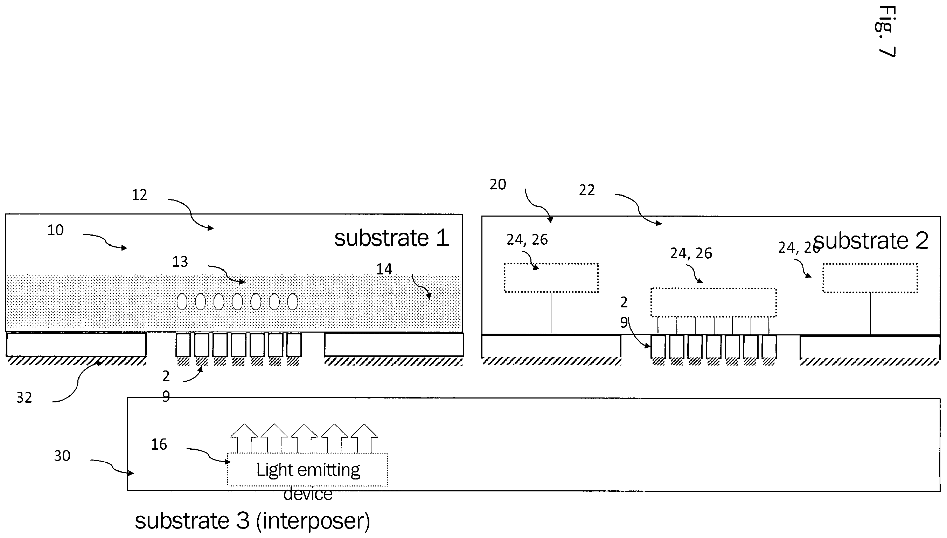

However, this is not limiting aspect of the invention and the control structures 24 and the read-out structures 26 can be developed on a third chip 30 as shown in Fig. 7. The second semiconductor substrate 22 and the third chip 30, in a non-limiting example, are made of silicon. According to this aspect, a light device 16 is integrated in the third chip 30.

The control structures 24 or the control-field structures are, for example, DC/AC magnetic fields (coils, microcoils, MW/RF antenna) transmission lines 29, magnetic structures and DC/AC electric fields (electrodes). The control structures 24 are used for generating the optical fields, electrical fields and/or magnetic fields as well as for controlling, initialization, manipulation, and read-out of a spin state of a given qubit in the first semiconductor substrate 12.

The read-out structures 26 are, for example, memory devices, logic devices, communication device, sensors, photonic devices, capacitors, FETs, current amplifiers, CMOS logic ICs.

According to one aspect, the second semiconductor substrate 22 has a front surface 22a and a back surface 22b. The front surface 22a and the back surface 22b of the second semiconductor substrate 22 may comprise a transparent substrate 25, the transmission lines 29, planar and/or vertical electrode structures and read-out structures 26.

The second semiconductor substrate 22 has on the front surface 22a the flip-chip bonding interconnection 32 configured to bond the second chip 20 to the first chip 10 as shown in Figs. 1-6. The flip-chip bonding interconnection 32 includes, for example, metallic contacts, insulating layers (dielectrics), magnetic structures, metal levels, and bonding sites for flip-chip techniques and for chip-to-package connections.

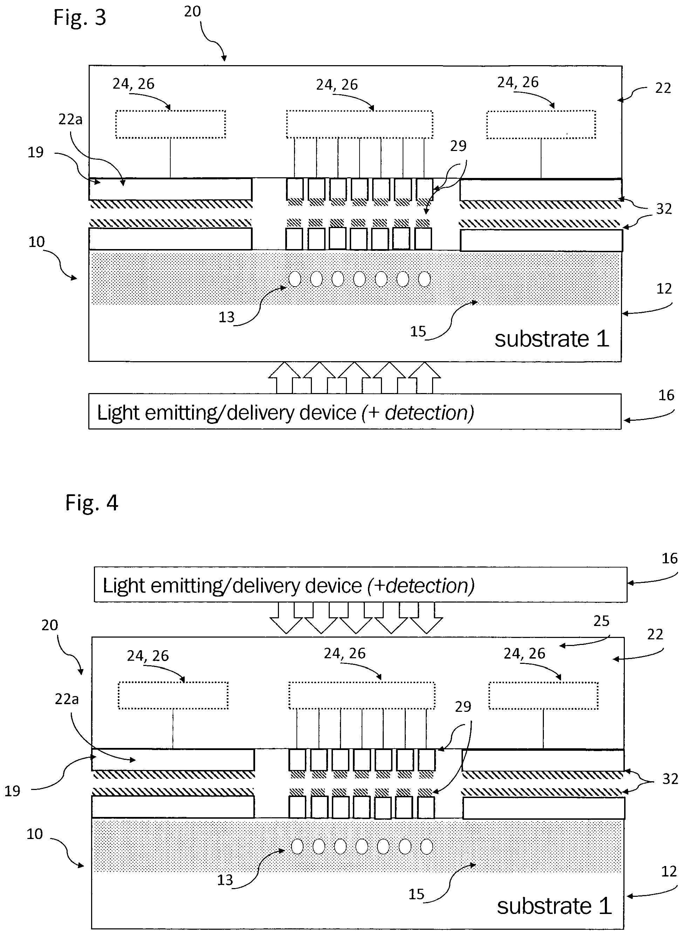

The light device 16 shown in Figs. 3-7 is used to emit and/or deliver and/or detect the optical fields to/from the first semiconductor substrate 12 or to/from the second semiconductor substrate 22. In one aspect, the light device 16 enables emitting of the optical fields and can be, but not limited to, a LED diode, a laser diode, a diode pumped solid state (DPSS). In a further aspect, the light device 16 enables delivering of the optical fields and can be, but not limited to, a fiber, a waveguide. In a further aspect, the light device 16 enables detection of the optical fields and can be, but not limited to, light meters, photometers, photodetectors, photodiodes. In a yet further aspect, the light device 16 may comprise optical filters, such as, but not limited to, notch filter, high-band pass filter or low-band pass filter.

According to Fig. 3, the light device 16 emits and/or delivers the optical fields via the first semiconductor substrate 12. In a non-limiting example, at least the part of the first semiconductor substrate 12 is transparent to visible and near infrared optical wavelengths.

Fig. 4 describes an alternative concept of the flip-chip assembly 1 with the transparent substrate 25. The transparent substrate 25 is transparent to visible and near infrared wavelengths allowing optical signals to be transmitted and collected through the flip-chip assembly 1, for example, the optical fields coming from the first semiconductor substrate 12. In example of Fig. 4, the optical fields are emitted from the light device 16 through the second semiconductor substrate 22 via the transparent substrate 25.

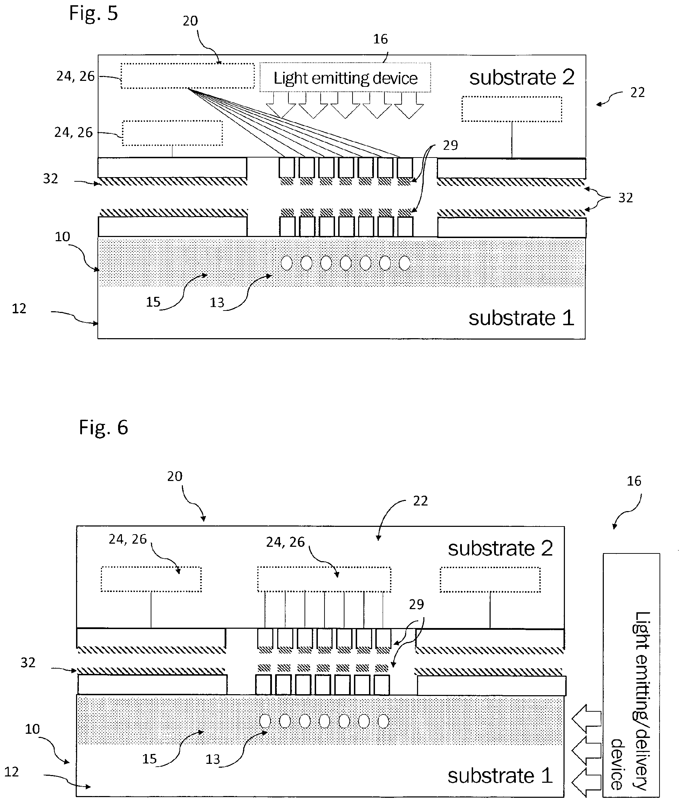

The light device 16 can be developed on a separate substrate or developed integrally with the flip-chip assembly 1 via a stacking and packaging. Fig. 5 shows the flip-chip assembly 1 with the light device 16 being integrated or fabricated into the second semiconductor substrate 22.

Fig. 6 shows the flip-chip assembly 1 illuminated from one side of the first semiconductor substrate 12 by the light device 16. The light device 16 activates the spin defects 13 of the first semiconductor substrate 12 by emitting the optical fields. The light device 16 is then used to read-out the qubits from the flip-chip assembly 1. According to the aspect of Fig. 6, the first semiconductor substrate 12 is transparent to visible and near infrared optical wavelengths.

The transmission lines 29 are used to transmit and to collect optical fields, electromagnetic fields (AC/DC currents, MW/RF signals), and radio-frequency fields through the flip-chip assembly 1. In a non-limiting example, the transmission lines 29 are transparent or semi-transparent to enable the optical transmission of visible optical signals or near infrared optical signals. The optical signals, radio-frequency signals, microwave signals, electromagnetic signals (AC/CD currents, MW/RF signals) generated in the first semiconductor substrate 12 can be transmitted through the transmission lines 29 to the second semiconductor substrate 22 through read-out structures 26 (e.g., electrodes) on the second semiconductor substrate 22 connected to the control field structures 24.

The transmission lines 29 can be provided either on the front surface 22a of the second semiconductor substrate 22 or on the top surface 14 of the first semiconductor substrate, but this is not limiting of the present invention. In one example, Fig. 1 shows the transmission lines 29 being provided on the first semiconductor substrate 12 and ones of the control structures 24 are developed on a front surface 22a of the second semiconductor substrate 22. In another example, Fig. 2 shows the transmission lines 29 being provided on the second semiconductor substrate 22 and ones of the control structures 24 are developed on the top surface 14 of the first semiconductor substrate 12.

The electrode structures of the front surface 22a of the second semiconductor substrate 22 and the read-out structures 26 allow the current to flow through the flip-chip assembly 1 between the first semiconductor substrate 12 and the second semiconductor substrate 22.

In a step of aligning, the top surface 14 of the first semiconductor substrate is aligned to the corresponding elements of the second semiconductor substrate 22. Verification of the alignment may be implemented by in-situ optical measurements, magnetometric measurements and electrometric measurements suitable for registering the qubit position(s). The registering of the qubit position(s) is implemented, for example, by optical imaging, and nuclear and electronic spin magnetic resonance spectroscopic techniques.

Final steps of the fabrication of the flip-chip assembly 1 may comprise necessary materials (e.g., flip-chip bonding interconnection 32) and/or surface preparations to achieve an interconnection between the first semiconductor substrate 12 and the second semiconductor substrate 22.

The flip-chip bonding interconnection 32 allows the interconnection of at least one of the first semiconductor substrate's surfaces (e.g., the top surface 14) with the at least one of the structure surface or device surface (e.g., the front surface 22a and the back surface 22b) of the second semiconductor substrate 22. The flip-chip bonding interconnection 32 comprise solder pads, metal pads, adhesive activated area, or surface activated area but this is not limiting of the invention.

The flip-chip bonding interconnection 32 is used for bonding of the flip-chip assembly 1 and can be implemented by, for example, metal-to-semiconductor bonding, metal-to-metal bonding, solder bump bonding or adhesive bonding, thermal compression bonding, vacuum bonding, eutectic-fusion bonding, and anodic bonding. Eutectic bonding is already used in the semiconductor industry to create electrical contacts (e.g., ohmic contacts, Schottky contacts).

In one aspect, the ISSQC fabrication process includes a testing and a packaging step. The testing step of the flip-chip assembly 1 is used to verify the alignment, bonding of the control structures 24, the read-out structures 26, the top surface 14 of the first semiconductor substrate 12, the front surface 22a and the back surface 22b of the second semiconductor substrate 22. The packaging step is the process where the flip-chip assembly 1 is packaged in a protective structure that allows for heat management, magnetic shielding, and electrical shielding over preferred frequency ranges.

For the packaging step, bonding a cap wafer to the flip-chip assembly 1 may provide the required protection in preparation for the subsequent process steps. The testing and packaging steps can take place prior to dicing, as sealing the ISSQC at the cap wafer level can provide higher levels of cleanliness.

In an alternative aspect, the fabrication of the second semiconductor substrate 22 with the control structures 24 and the read-out structures 26 is separated from the fabrication of the first semiconductor substrate 12. In this alternative aspect, shown in Fig. 2, the control structures 24 (e.g., microcoils, contacts, electrode structures) are fabricated directly onto the top surface 14 of the first semiconductor substrate 12. According to this aspect, the read-out structures 26 and the flip-chip bonding interconnection 32 are fabricated on the second semiconductor substrate 12.

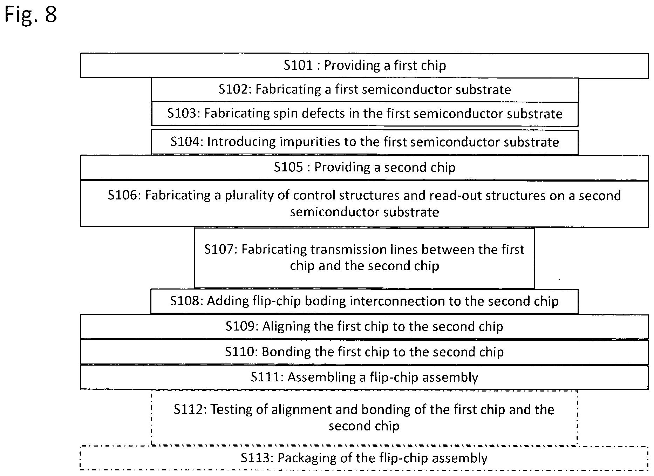

Fig. 8 shows a flow diagram for the method of assembling of the integrated solid-state quantum circuit.

In step S101, the first chip 10 is provided. The first semiconductor substrate 12 is fabricated on the first chip 10 in step S102. The first semiconductor substrate 12 is made of diamond.

In step S103, the spin defects 13 are fabricated in the first semiconductor substrate 12 through one of atomic-scale fabrication, particle irradiation, ion implantation or laser irradiation. As previously described, the spin defects 13 can be grown onto the top surface 14 of the first semiconductor substrate 12 or distributed in a bulk of the first semiconductor substrate 12. The activation, generation, and conversion of all spin defects 13 or at least some of the spin defects 13 into qubits can be controlled via chemical procedures, electrical procedures, optical procedures, or thermal procedures (e.g., annealing).

In step S104, the dopant elements 15 are introduced in the first semiconductor substrate 12. Introduction of the dopant elements 15 of the step 104 can take a place before the step S103 or at the same time as the step S103.

In step S105, the second chip 20 is provided on which the plurality of control structures 24 and read-out structures 26 are fabricated in step S106. In an alternative embodiment, the control structures 24 are fabricated on the top surface 14 of the first semiconductor substrate 12 and the transmission lines 29 are fabricated on the back surface 22b of the second semiconductor substrate 22. The read-out structures 26 are fabricated on the second semiconductor substrate 22.

In step S107, the transmission lines 29 are fabricated on the second semiconductor substrate 22. In an alternative embodiment, transmission lines 29 are fabricated on the first semiconductor substrate 12. The transmission lines 29 allow the electromagnetic fields to be transmitted and collected through the flip-chip assembly 1. The optical signals, radio-frequency signals, microwave signals can be transmitted through the transmission lines 29.

The transmission lines 29 are fabricated using, for example, metal deposition, sputtering, evaporation, CVD, optical lithography, photolithography, e-beam lithography, and soft lithography.

In step S108, the flip-chip bonding interconnection 32 is added to the second semiconductor substrate 22. The flip-chip bonding interconnection 32 allows for the interconnection of at least one surface of the first semiconductor substrate 12 to the at least one surface of the second semiconductor substrate 22 (e.g., the front surface 22a or the back surface 22b). Solder pads, metal pads, adhesive activated area or surface activated area can be used to achieve the flip-chip bonding interconnection 32.

In step S109, surfaces of the first chip 10 and surfaces of the second chip 20 are aligned in order to establish controls and readout of individual or multiple qubits in the first semiconductor substrate 12. In alternative embodiment, the surfaces of the second chip 20 and/or the surfaces of the third chip 30 are aligned with the first chip 10 as shown in Fig. 7.

In step S110, the first chip 10 is bonded to the second chip 20 using at least one of methods: flip-chip bonding, solder bump or adhesive bonding, thermal-compression bonding, vacuum bonding, eutectic-fusion bonding, and anodic bonding.

In an assembly step S111, the flip-chip assembly 1 is assembled.

In a testing step S112, the flip-chip assembly 1 is tested in order to verify the successful alignment of the control structures 24, the transmission lines 29 and bonding of the surfaces of the first chip 10 and the surfaces of the second chip 10 with surfaces of the control structures 24 and the readout structures 26. The step S112 is an optional step, and the flip-chip assembly 1 can be packaged (in step S113) directly after the step S111 if necessary. It will also be appreciated that the assembly step S111 and the testing step S112 can be carried out in parallel.

In a packaging step S113, the flip-chip assembly 1 is packaged in the protective structure that allows for thermal management and magnetic shielding and electrical shielding and irradiation shielding of the flip-chip assembly 1 from external field sources. According to one example, the packaging step S113 can be an optional step.

### Reference numerals

- 1: - Flip-chip assembly
- 10: - First chip
- 12: - First semiconductor substrate
- 13: - Spin defect
- 14: - Top surface of the first semiconductor substrate
- 15: - Dopant element
- 16: - Light device
- 20: - Second chip
- 22: - Second semiconductor substrate
- 22a: - Front surface
- 22b: - Back surface
- 25: - Transparent substrate
- 24: - Control structure
- 26: - Read-out structure
- 29: - Transmission lines
- 30: - Third chip
- 32: - Flip-chip bonding interconnection

## Claims

1. A flip-chip assembly (1) of an integrated solid-state quantum circuit comprising:
- a first chip (10) hosting a plurality of qubits in a first semiconductor substrate (12),
- a second chip (20) comprising a second semiconductor substrate (22) bonded to the first chip (10), wherein the second chip (20) comprises a plurality of control structures (24) and read-out structures (26),
wherein the first semiconductor substrate (12) is a diamond substrate.

2. The flip-chip assembly (1) of claim 1, wherein the first semiconductor substrate (12) comprises at least one spin defect (13), and wherein the at least one spin defect (12) is at least one of a surface spin defect or a bulk spin defect.

3. The flip-chip assembly of any of the above claims, wherein the first semiconductor substrate (12) further comprises impurities selected from at least one of boron, aluminum, gallium, indium, thallium, nihonium, nitrogen, phosphorus, arsenic, antimony, bismuth, beryllium, lithium.

4. The flip-chip assembly of claim 1, wherein the read-out structures (26) are integrated into a third chip (30).

5. The flip-chip assembly of claim 1, wherein the second semiconductor substrate (20) comprises a transparent material.

6. A method of assembling of an integrated solid-state quantum circuit comprising
- providing a first chip (10) hosting a plurality of qubits in a first semiconductor substrate (12), wherein the first semiconductor substrate (12) is a diamond substrate;
- fabricating a plurality of control structures (24) and read-out structures (26) onto a second semiconductor substrate (22);
- aligning the first chip (10) to the second chip (20); and
- bonding of the first chip (10) to the second chip (20), thereby forming a flip-chip assembly (1).

7. The method of claim 6, further comprising atomic-scale fabrication of a spin defect (13) in the first semiconductor substrate (12).

8. The method of claim 7, wherein the spin defect (13) is controlled via chemical, electric, thermal, optical procedures, or ion irradiation.

9. The method of claim 6, wherein bonding of the first chip (10) to the second chip (20) is carried out by at least one of metal-to-semiconductor bonding, metal-to-metal bonding, solder bump bonding, adhesive bonding, thermal-compression bonding, vacuum bonding, eutectic-fusion bonding, or anodic bonding.

10. The method of claim 6, wherein the plurality of control structures (24) and read-out structures (26) are developed onto a third chip (30).

11. The method of claim 6, further comprising testing of the flip-chip assembly (1), wherein testing of the flip-chip assembly (1) comprises verification of alignment and bonding of the first chip (10) and the second chip (20).

12. The method of claim 6, further comprising aligning of at least one of the third chip (30) or the second chip (20) to the first chip (10).

13. The method of claim 6, further comprising packaging of the flip-chip assembly (1) comprising at least one of thermal management or electric shielding, magnetic shielding, or irradiation shielding.
